# EUROPEAN PATENT APPLICATION

(11) **EP 4 708 658 A1**
(43) Date of publication of application: **11.03.2026**
(21) Application number: 25197307.9
(22) Date of filing: 21.08.2025
(51) Int. Cl.: H02M 3/156, H02M 3/158, H02M 1/32, H02M 1/36, H02M 1/00

(54) **SWITCHING POWER SUPPLY**

(30) Priority: 30.08.2024 CN 202411217223
(71) Applicant: Silergy Semiconductor Technology (Hangzhou) Ltd, Hangzhou City, Zhejiang 310051 (CN)
(72) Inventor: ZENG, Qi'an, Hangzhou City, 310051 (CN); CHEN, Huiqiang, Hangzhou City, 310051 (CN)
(74) Representative: Viering, Jentschura & Partner mbB Patent- und Rechtsanwälte

(57) **Abstract**

The present disclosure provides a switching power supply. The operating states of the bus protection switch is controlled to generate a low current, which charges the output capacitor during the short-circuit detection phase. A short-circuit fault of the switching power supply can be identified by monitoring whether the output voltage rises to a predetermined value. Unlike conventional methods, this approach eliminates the need for bus detection resistors and differential sampling, thereby reducing the number of required chip pins and simplifying chip design. Additionally, during the soft-start phase, the power-on duration is extended and the peak of charging current to the output capacitor is reduced, allowing the output voltage to rise gradually, thereby slowing the ramp rate of the output voltage, enabling the output voltage to reach the input voltage, reducing power loss, improving system efficiency, and enhancing operational safety.

## Description

### FIELD OF THE INVENTION

The present disclosure relates to the technical field of power electronics, and more particularly, to a switching power supply and a short-circuit detection method for the same.

### BACKGROUND OF THE INVENTION

A boost converter, is a non-isolated step-up circuit known for its simple architecture and low cost, and is widely used in applications that do not require electrical isolation. However, when the boost converter powers up, the sudden change in voltage can result in a large surge current, which may damage electronic components.

Thus, preventing such surge currents during power-up, particularly in boost converters, has become an urgent technical challenge in the field. Additionally, during the power-on phase, if the output terminal or the non-grounded terminal of the main power switch is shorted to ground, a large current may flow through the input bus, potentially causing further damage of electronic devices.

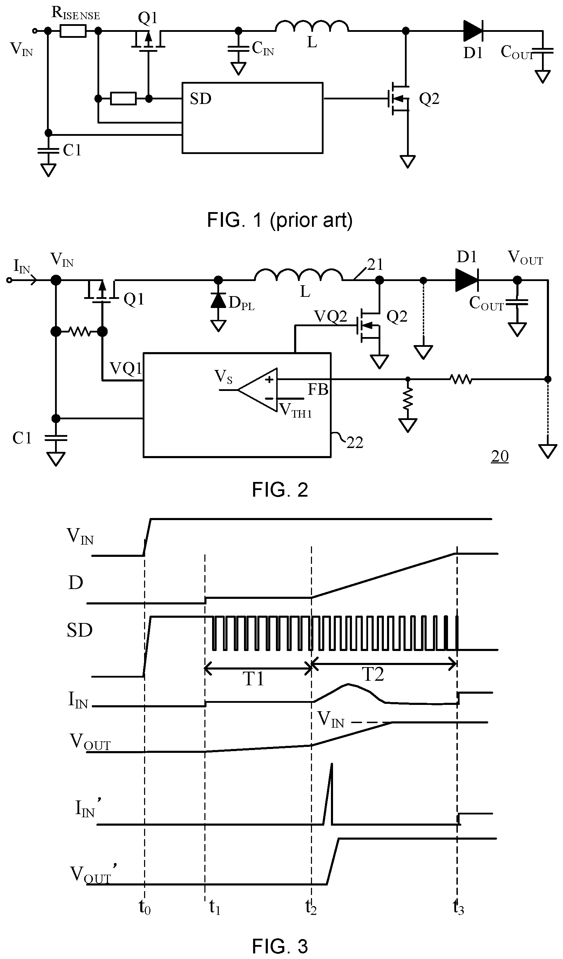

A conventional approach, shown in FIG. 1, involves a boost-based switching power supply that includes a bus sensing resistor R_{ISENSE}, a bus switch Q1, a boost converter, and an output capacitor C_{OUT}. In this setup, short-circuit detection can be performed by monitoring the voltage across the bus sensing resistor R_{ISENSE}, which requires the control circuit to include two dedicated high-side sampling pins to sample the voltages of two ends of the bus sensing resistor R_{ISENSE} respectively, so as to capture the voltage across the bus sensing resistor R_{ISENSE}. When the output terminal of switching power supply is shorted to ground, or when the common node of switch Q2 and diode D1 in the boost converter is shorted to ground, a large current flows through the input bus, which results in a voltage across the bus sensing resistor R_{ISENSE} that exceeds a predefined threshold, thereby triggering the short-circuit protection and turning off the bus switch Q1. However, this method not only requires additional detection pins but also results in power loss across the bus sensing resistor R_{ISENSE}, reducing overall system efficiency.

### SUMMARY OF THE INVENTION

The present disclosure provides a switching power supply and a short-circuit detection and soft-start method for the same, which reduces the number of chip pins while improving system efficiency and safety.

The switching power supply comprises a boost converter, a bus protection switch and a first diode.

The boost converter is configured to perform voltage conversion on an input voltage of an input terminal of the switching power supply to generate an output voltage of an output terminal of the switching power supply in a normal operating phase.

The bus protection switch is connected between the input terminal of the switching power supply and the boost converter, and is configured to be turned off in response to a short-circuit fault of the switching power supply.

The first diode is connected between a common node between the bus protection switch and the boost converter and a ground terminal.

A duty cycle of the bus protection switch is controlled to make the output voltage rises slowly in at least part of a startup phase, such that a short-circuit detection is performed.

The bus protection switch, the first diode, and an inductor in the boost converter form a buck converter, and the buck converter is configured to receive the input voltage, and convert the input voltage into the output voltage in the startup phase.

Preferably, the switching power supply further comprises a control circuit. The control circuit is configured to control the buck converter to operate in a first time interval of the startup phase, to make the output voltage rise gradually. In the first time interval, the control circuit determines whether the switching power supply has a short-circuit fault by comparing a feedback signal of the output voltage and a first threshold.

Preferably, when the feedback signal of the output voltage is detected to be lower than the first threshold, the control circuit determines that the switching power supply has a short-circuit fault; and when the feedback signal of the output voltage can rise to the first threshold, the control circuit determines that no short-circuit fault is present in the switching power supply.

Preferably, when the feedback signal of the output voltage rises to the first threshold during the first time interval, the control circuit is configured to initiate a soft start of the switching power supply in a second time interval of the startup phase, wherein the second time interval is after the first time interval.

Preferably, when the feedback signal of the output voltage is detected to be lower than the first threshold during the first time interval of the startup phase or in the normal operating phase, the control circuit is configured to turn off the bus protection switch or be controlled to stop operating, and then reenter the startup phase after a predetermined delay.

Preferably, in the second time interval, the control circuit controls the output voltage generated by the buck converter to soft start the switching power supply, to make the output voltage rise and approach the input voltage.

Preferably, the buck converter has a first duty cycle range in the first time interval and a second duty cycle range in the second time interval. Every value within the second duty cycle range is greater than any value within the first duty cycle range.

Preferably, the buck converter has a predetermined first duty cycle in the first time interval and a second duty cycle range in the second time interval. Every value within the second duty cycle range is greater than the predetermined first duty cycle.

Preferably, a second duty cycle of the buck converter increases and remains within the second duty cycle range during the second time interval. A maximum value of the second duty cycle range is 1.

Preferably, the bus protection switch is a P-type field effect transistor, a source of the bus protection switch is connected to the input terminal of the switching power supply, and a drain of the bus protection switch is connected to the boost converter.

Preferably, a short-circuit protection is implemented in the switching power supply without disposing a sampling circuit between the input terminal of the switching power supply and the boost converter.

Preferably, the soft start of the switching power supply in the second time interval is implemented by controlling the operating states of the bus protection switch to reduce a change rate of a current of the inductor.

Preferably, in the second time interval of the startup phase, the buck converter has a fixed third duty cycle within the second duty cycle range.

Preferably, the buck converter is controlled to operate to make a current of the inductor is within a preset current range in a first time interval of the startup phase, so the output voltage rises slowly to perform the short-circuit detection.

Preferably, the switching power supply further comprises an input capacitor coupled to the first diode. The duty cycle of the bus protection switch is controlled in a first time interval of the startup phase, to make the output voltage rises slowly to perform the short-circuit detection.

The present disclosure provides a switching power supply. The operating states of the bus protection switch is controlled to generate a low current, which charges the output capacitor during the short-circuit detection phase. A short-circuit fault of the switching power supply can be identified by monitoring whether the output voltage rises to a predetermined value. Unlike conventional methods, this approach eliminates the need for bus detection resistors and differential sampling, thereby reducing the number of required chip pins and simplifying chip design. Additionally, during the soft-start phase, the power-on duration is extended and the peak of charging current to the output capacitor is reduced, allowing the output voltage to rise gradually, thereby slowing the ramp rate of the output voltage, enabling the output voltage to reach the input voltage, reducing power loss, improving system efficiency, and enhancing operational safety.

### BRIEF DESCRIPTION OF DRAWINGS

In order to more clearly illustrate the technical solutions in the embodiments of the present disclosure, the following is a brief description of the accompanying drawings to be used in the description of the embodiments. It is obvious that the following description of the accompanying drawings is only about embodiments of the present invention. For the person of ordinary skill in the art, other drawings can be obtained without creative work, according to these accompanying drawings.
FIG. 1 is a schematic diagram of a switching power supply in the prior art.
FIG. 2 is a schematic diagram of a switching power supply according to a first embodiment of the present disclosure.
FIG. 3 is an operating waveform diagram of the switching power supply according to the first embodiment of the present disclosure.
FIG. 4 is a schematic diagram showing a portion of a driving voltage generation circuit of a bus protection switch within the switching power supply according to the first embodiment of the present disclosure.
FIG. 5 is an operating waveform diagram of the driving voltage generation circuit of the bus protection switch within the switching power supply according to the first embodiment of the present disclosure.
FIG. 6 is a schematic diagram of a switching power supply according to a second embodiment of the present disclosure.

### DETAILED DESCRIPTION OF THE INVENTION

The following description of the present disclosure is based on exemplary embodiments; however, the present disclosure is not restricted to these embodiments. In the detailed description below, specific details are provided to facilitate a thorough understanding of the present disclosure. It will be apparent to those skilled in the art that the present disclosure can be practiced without these specific details. To avoid obscuring the essence of the present disclosure, well-known methods, processes, procedures, components, and circuits are not described in detail.

Moreover, it should be understood by those skilled in the art that the accompanying drawings are provided for illustrative purposes and are not necessarily drawn to scale.

It should be understood that in the following description, a "circuit" refers to a conductive loop formed by at least one component or sub-circuit through electrical or electromagnetic connections. When a component or circuit is described as "connected to" another component or as "connected between" two nodes, it can be directly coupled or connected to the other component, or there may be intermediate components. The connections between components can be physical, logical, or a combination of both. Conversely, when a component is described as "directly coupled to" or "directly connected to" another component, it means that there are no intermediate components between them.

The terms "comprising", "including", and similar terms throughout the present disclosure should be interpreted as inclusive rather than exclusive or exhaustive; that is, meaning "including, but not limited to."

It should be understood that the terms "first" and "second" are used for indication purpose only and should not be construed as indicating or implying relative importance. In the present disclosure, "a plurality of" means two or more, unless otherwise expressly specified.

FIG. 2 is a schematic diagram of a switching power supply 20 according to a first embodiment of the present disclosure. As shown in FIG. 2, the switching power supply 20 comprises a boost converter 21, a bus protection switch Q1 and a control circuit 22.

The boost converter 21 is configured to perform voltage conversion on a direct current (DC) input voltage V_{IN} of an input terminal of the switching power supply to generate an output voltage V_{OUT} of an output terminal of the switching power supply in a normal operating phase. In the first embodiment, the boost converter 21 comprises an inductor L, a main power transistor Q2, a diode D1 and an output capacitor C_{OUT}. The inductor L is coupled to the input terminal of the switching power supply. The main power transistor Q2 is connected to the inductor L. The diode D1 is connected to both the inductor L and the main power transistor Q2. The output capacitor C_{OUT} is connected to the output terminal of the switching power supply, and the voltage across the output capacitor C_{OUT} is used as the output voltage V_{OUT}.

The bus protection switch Q1 is connected between the input terminal of the switching power supply 20 and the boost converter 21. Specifically, a first power terminal of the bus protection switch Q1 is connected to the input terminal of the switching power supply 20, and a second power terminal of the bus protection switch Q1 is connected to a first terminal of the inductor L in the boost converter 21. The bus protection switch Q1 is turned off when a short-circuit fault occurs in the switching power supply 20, that is, the bus protection switch Q1 is turned off when a short-circuit detection signal Vs output by the control circuit 22 becomes valid. For example, when the output terminal of the switching power supply 20 is shorted to ground, or a non-grounded terminal of the main power transistor Q2 is shorted to ground, the short-circuit detection signal Vs is valid, to prevent large current from being generated on an input bus, thereby protecting the electronic device from damage.

The switching power supply 20 further comprises a first diode D_{PL}, a cathode of the first diode D_{PL} is connected to a common node between the bus protection switch Q1 and the boost converter 21, and an anode of the first diode D_{PL} is connected to a ground terminal. Further, the bus protection switch Q1, the first diode D_{PL} , and the inductor L in the boost converter 21 can form a buck converter. The control circuit 22 controls the buck converter to operate in a first time interval of a startup phase of the switching power supply, to make a current of the inductor L is within a preset current range, such that the output voltage V_{OUT} rises slowly and a short-circuit detection is performed. In a second time interval of a startup phase, the control circuit 22 adjusts the output voltage V_{OUT} to initiate a soft start of the switching power supply 20, making the output voltage V_{OUT} to rise and approach the input voltage V_{IN}, wherein the second time interval is after the first time interval.

Preferably, the bus protection switch Q1 is a P-type field effect transistor, a source (i.e., the first power terminal) of the bus protection switch Q1 is connected to the input terminal of the switching power supply 20, a drain (i.e., the second power terminal) of the bus protection switch Q1 is connected to the first terminal of the inductor L in the boost converter 21, and a control terminal of the bus protection switch Q1 receives a control signal VQ1 output by the control circuit 22. When a value of the control signal VQ1 lower than the input voltage V_{IN} (i.e., a difference between the control signal VQ1 and the input signal V_{IN}) exceeds a turn-on threshold of the bus protection switch Q1, the bus protection switch Q1 is completely turned on.

In the present disclosure, the control circuit 22 is configured to perform short-circuit detection on the switching power supply 20 in the first time interval of the startup phase, and control the operating states of the bus protection switch Q1 so that the current of the inductor L is maintained within the preset current range in the short-circuit detection phase. In the first time interval, the short-circuit detection signal Vs is generated by comparing a feedback signal FB of the output voltage V_{OUT} and the first thresholdV_{TH1}. In one embodiment, in the first time interval, the short-circuit detection signal Vs is generated by determining whether a feedback signal FB of the output voltage V_{OUT} is lower than the first threshold V_{TH1}.

Further, when the short-circuit detection is performed, the control circuit 22 controls the operating states of the bus protection switch Q1, such that the current of the inductor L is maintained within the preset current range. The preset current range is small and less than the inductor current when the boost converter 21 operates in a normal operating phase. When the short-circuit detection is performed, the current of the inductor L charges the output capacitor C_{OUT}, and when both the output terminal of the switching power supply 20 and the non-grounded terminal of the main power transistor Q2 are not grounded, the output voltage V_{OUT} across the output capacitor C_{OUT} gradually rises and can reach the first threshold V_{TH1}, and when either the output terminal of the switching power supply 20 or the non-grounded terminal of the main power transistor Q2 is short-circuited to the ground, the output voltage V_{OUT} on the output capacitor C_{OUT} remains near zero and cannot reach the first threshold V_{TH1}. Based on this, when the feedback signal FB of the output voltage V_{OUT} is detected to be lower than the first threshold V_{TH1}, the control circuit 22 determines that the switching power supply has a short-circuit fault and outputs a valid short-circuit detection signal Vs; and when the feedback signal FB of the output voltage V_{OUT} rises to the first threshold V_{TH1}, the control circuit 22 determines that no short-circuit fault is present in the switching power supply 20 and outputs an invalid short-circuit detection signal Vs.

In the first embodiment, as shown in FIG. 2, the feedback signal FB is input to a non-inverting input terminal of a comparator, and the first threshold V_{TH1} is input to an inverting input terminal of the comparator. When the feedback signal FB is lower than the first threshold V_{TH1}, the short-circuit detection signal Vs output by an output terminal of the comparator is low level, that is, the valid short-circuit detection signal Vs is configured to be at a low level, and the invalid short-circuit detection signal Vs is configured to be at a high level. It can be understood that, in other embodiments, the valid short-circuit detection signal Vs may also be configured to be at a high level, and the invalid short-circuit detection signal Vs is configured to be at a low level, which does not restrict the level of the valid signal and the level of the invalid signal.

Further, the control signal VQ1 of the bus protection switch Q1 is determined based on the short-circuit detection signal Vs and a pulse-width-modulation (PWM) signal SD. Specifically, when the short-circuit detection signal Vs is valid, that is, when the switching power supply has a short-circuit fault, the control signal VQ1 is configured to enable the bus protection switch Q1 to be turned off; and when the short-circuit detection signal Vs is invalid, that is, when no short-circuit fault is present in the switching power supply, the control signal VQ1 is configured to be consistent with the PWM signal SD of the bus protection switch Q1 in the startup phase. It should be noted that the duty cycle of the PWM signal SD of the bus protection switch Q1 in the startup phase is configured to a predetermined duty cycle D.

Based on the above short-circuit detection principle, the switching power supply of the present disclosure eliminates the need to dispose a sampling circuit (such as the bus detection resistor R_{ISENSE} in FIG. 1) between the input terminal of the switching power supply 20 and the boost converter 21 for short-circuit protection. When the small inductor current is charged to the output capacitor C_{OUT}, and either the output terminal of the switching power supply 20 or the switching node (i.e., the non-grounded terminal) of the main power transistor Q2 is short-circuited to the ground, the output voltage V_{OUT} cannot rise to the predetermined value (i.e., the first threshold V_{TH1}), thereby triggering the short-circuit protection, and turning off the bus protection switch Q1.

When the feedback signal FB of the output voltage V_{OUT} is detected to be lower than the first threshold V_{TH1} during the first time interval of the startup phase or in the normal operating phase (i.e., when the switching power supply 20 has a short-circuit fault), the control circuit 22 is configured to turn off the bus protection switch Q1 or be controlled to stop operating, and then reenter the startup phase after a predetermined delay.

When it is detected that the feedback signal FB of the output voltage V_{OUT} rises to the first threshold V_{TH1} during the first time interval (i.e., when no short-circuit fault is present in the switching power supply 20), the control circuit 22 is configured to initiate the soft start of the switching power supply 20 in the second time interval of the startup phase, so that the output voltage V_{OUT} is close to the input voltage V_{IN}. wherein the second time interval is after the first time interval.

In the present disclosure, the control circuit 22 is configured to soft start the switching power supply 20 in the second time interval, and in the soft-start phase, the control circuit 22 controls the operating states of the bus protection switch Q1, such that the output voltage V_{OUT} continues to rise and gradually approaches the input voltage V_{IN}. In the soft-start phase, the control circuit 22 adjusts the output voltage V_{OUT} by adjusting the duty cycle of the control signal VQ1 of the bus protection switch Q1. The present disclosure aims to achieve soft start of the switching power supply by reducing a change rate of the current flowing through the inductor L (i.e., the inductor current), that is, prolonging the time the inductor current takes to reach its peak value, or reducing the amplitude of the peak value of the inductor current.

In the present disclosure, the purpose of soft start is that, in the process of turning on the bus protection switch Q1, the current flowing through the inductor L may not have a large peak, and the output voltage V_{OUT} can not exceed the input voltage V_{IN}. As an example, the buck converter has a first duty cycle range in the first time interval and a second duty cycle range in the second time interval. Every value within the second duty cycle range is greater than any value within the first duty cycle range.

As an example, the buck converter has a predetermined first duty cycle in the first time interval and a second duty cycle range in the second time interval. Every value within the second duty cycle range is greater than the predetermined first duty cycle.

As an example, during the second time interval, the buck converter has a second duty cycle that gradually increases and remains within the second duty cycle range, wherein with a maximum value of the second duty cycle range is 1.

As an example, in the second time interval of the startup phase, the buck converter has a fixed third duty cycle within the second duty cycle range.

As an example, after the startup phase of the switching power supply 20, the switching power supply 20 enters the normal operating phase, during which the control signal VQ2 controls the main power transistor Q2 in the boost converter 21 to be periodically turned on and off, and the boost converter 21 performs voltage conversion on the DC input voltage V_{IN} to generate the output voltage V_{OUT}.

FIG. 3 is an operating waveform diagram of the switching power supply according to the first embodiment of the present disclosure, and the operating process of the whole startup phase of the switching power supply 20 is described below with reference to FIGs. 2 and 3. In FIGs. 2 and 3, D is the duty cycle of the buck converter in the startup phase, SD is the PWM signal corresponding to the duty cycle D, I_{IN} is the current flowing through the bus protection switch Q1, and the bus protection switch Q1 is a P-type field effect transistor.

At moment t₀, the switching power supply 20 is powered on, the input voltage V_{IN} starts to rise, at which time, both the bus protection switch Q1 and the main power transistor Q2 are in an off state, the duty cycle D is 0, the PWM signal SD is close to the input voltage V_{IN}, and the input current I_{IN} is 0.

The interval from t₁ to t₂ is the first time interval (i.e., T1) of the startup phase, serving as the short-circuit detection period. At moment t₁, the control circuit 22 starts operating, and the buck converter begins functioning. In the present embodiment, the buck converter operates at the predetermined first duty cycle in the first time interval, the predetermined first duty cycle is relatively small (for example, near 5%), so that the current flowing through the inductor L is within the preset current range for short-circuit detection. During the short-circuit detection phase, when the switching power supply 20 is determined to be in a non-short-circuit condition, the output voltage V_{OUT} rises gradually and the switching power supply 20 enters the second time interval (T2); and when the switching power supply 20 is determined to be in a short-circuit condition, the switching power supply 20 is first turned off and then reenter the startup phase after a predetermined delay.

FIG. 3 also shows waveforms of input current I_{IN}' and output voltage V_{OUT}' of the switching power supply without setting a soft start. As shown in FIG. 3, in a solution without soft start, when the bus protection switch Q1 is directly turned on at a certain moment after the moment t₂, a large current spike may be formed on the inductor L, and the current peak is too large to cause damage to the electronic device, and a large inductor voltage may be formed at two ends of the inductor L, at which time, a sum of the inductor voltage and the input voltage V_{IN} is equal to the output voltage V_{OUT}', which may result in an excessively high output voltage V_{OUT}'.

It should be noted that, in other embodiments, the buck converter may also operate in the first duty cycle range, that is, the buck converter may operate at a fixed duty cycle or a varying duty cycle, which is not limited in the present disclosure, as long as it can be ensured that the current flowing through the inductor is within the preset current range, allowing the output voltage V_{OUT} to gradually rise.

From t₂ to t₃: the switching power supply enters the second time interval (i.e., the soft-start phase) at moment t₂, the duty cycle D gradually increases, and the effective level (here the low level) of the PWM signal SD increases accordingly. In this interval, the input current I_{IN} rises initially and then decreases, and when the output voltage V_{OUT} continues to rise and gradually approaches the input voltage V_{IN}, the input current I_{IN} drops to zero and remains stable. At moment t₃, the second time interval of the startup phase concludes, the switching power supply transitions into the normal operating phase, the bus protection switch Q1 is fully turned on, and the boost converter 21 begins functioning. During the soft-start phase, since the duty cycle D of the buck converter gradually increases, the peak value of the charging current to the output capacitor C_{OUT} is reduced, and the output voltage V_{OUT} slowly rises to prolong the power-on time, thereby reducing the power consumption in the soft-start phase.

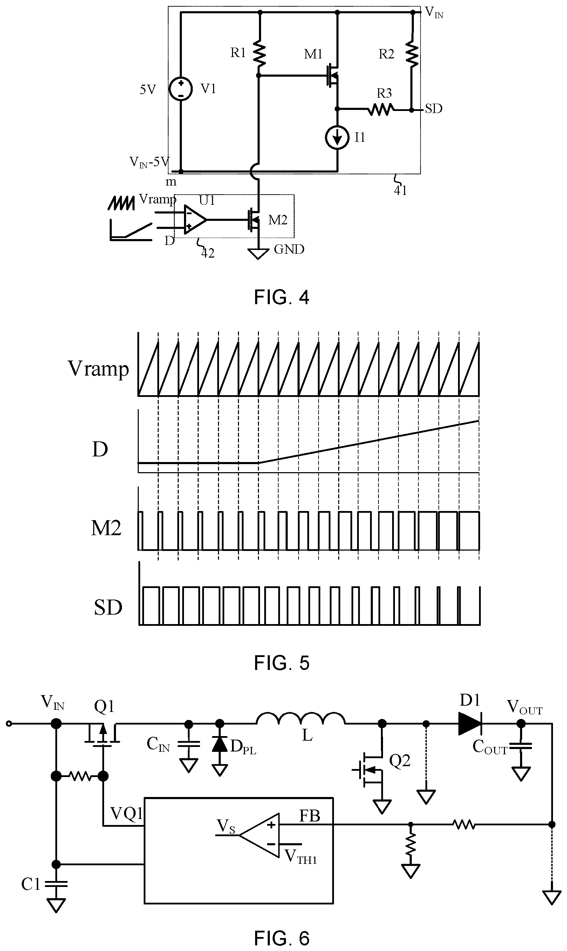

FIG. 4 is a schematic diagram showing a portion of a driving voltage generation circuit of the bus protection switch within the switching power supply according to the first embodiment of the present disclosure. FIG. 5 is an operating waveform diagram of the driving voltage generation circuit of the bus protection switch within the switching power supply according to the first embodiment of the present disclosure. The circuit shown in FIG. 4 is used for generating the PWM signal SD. The circuit may be divided into a driving voltage circuit 41 and a driving timing circuit 42.

In a preferred embodiment, the driving voltage circuit 41 comprises a voltage source V1, a transistor M1, a current source I1, and resistors R1, R3 and R2. The transistor M1 and the current source I1 are connected in series to form a series structure, and the series structure is connected in parallel with the voltage source V1. A first power terminal of the transistor M1 and a positive electrode of the voltage source V1 both receive the input voltage V_{IN}, and the resistor R1 is connected between the first power terminal of the transistor M1 and a control terminal of the transistor M1. The resistors R2 and R3 are connected in series between the two power terminals of the transistor M1, and the PWM signal SD is generated at a common node between the resistors R2 and R3.

The driving timing circuit 42 comprises a comparator U1 and a transistor M2. A non-inverting input terminal of the comparator U1 receives the duty cycle signal representing the change curve of the duty cycle D, an inverting input terminal of the comparator U1 receives the ramp signal Vᵣₐₘₚ, an output terminal of the comparator U1 outputs the comparison signal to a control terminal of the transistor M2.

A first power terminal of the transistor M2 is connected to the control terminal of the transistor M1, and a second power terminal of the transistor M2 is grounded. The driving voltage circuit 41 also includes a logic circuit, which is used to generate the control signal VQ1 of the bus protection switch Q1 based on the short-circuit detection signal Vs and the PWM signal SD. Specifically, when the short-circuit detection signal Vs is valid, the control signal VQ1 is configured to enable the bus protection switch Q1 to be turned off; and when the short-circuit detection signal Vs is invalid, the control signal VQ1 is configured to be consistent with the PWM signal SD of the bus protection switch Q1 in the startup phase. During the normal operating phase, the PWM signal SD remains at an active level, the short-circuit detection signal Vs is an inactive level, and the control signal VQ1 controls the bus protection switch Q1 to be fully turned on.

The operating principle of the circuit used for generating the PWM signal SD is described below with reference to FIGs. 4 and 5. When the duty cycle D is greater than the ramp signal Vᵣₐₘₚ, the comparison signal output by the comparator U1 is a high level, such that the transistor M2 is turned on. When the transistor M2 is turned on, the control terminal of the transistor M1 is pulled low, the transistor M1 is turned off. Consequently, the current source I1 flows through the resistor R2, so a voltage drop of R2 * I1 between the input voltage V_{IN} and the output terminal of the PWM signal SD is generated, such that the difference between the input voltage V_{IN} and the PWM signal SD exceeds a turn-on threshold of the bus protection switch Q1, thereby ensuring the bus protection switch Q1 is fully turned on. When the duty cycle D is lower than the ramp signal Vᵣₐₘₚ, the comparison signal output by the comparator U1 is a low level, such that the transistor M2 is turned off. When the transistor M2 is turned off, the control terminal of the transistor M1 is pulled up to the input voltage V_{IN} through the resistor R1, the transistor M1 is turned on. Consequently, the output terminal of the PWM signal SD is shorted to the input voltage V_{IN} via the transistor M1, resulting in the bus protection switch Q1 being turned off.

It should be noted that, in the first embodiment, the bus protection switch Q1 operates with a fixed first duty cycle during the first time interval of the startup phase, and with a progressively increasing duty cycle within the second duty cycle range during the second time interval of the startup phase. This is provided merely as an example and does not restrict the scope of the present disclosure. For example, a progressively increasing duty cycle may be adopted during the first time interval, or a fixed duty cycle may be used in the second time interval. Alternatively, the bus protection switch Q1 may be fully turned on throughout the second time interval. The present disclosure does not impose any restrictions on the circuit structure used to generate the PWM signal SD, so long as the circuit structure can make the PWM signal SD consistent with the variation trend or curve of the predetermined duty cycle D.

The present disclosure provides a short-circuit detection method that controls the operating states of the bus protection switch to generate a low current, which charges the output capacitor during the short-circuit detection phase. A short-circuit fault of the switching power supply can be identified by monitoring whether the output voltage rises to a predetermined value. Unlike conventional methods, this approach eliminates the need for bus detection resistors and differential sampling, thereby reducing the number of required chip pins and simplifying chip design. Additionally, during the soft-start phase, the power-on duration is extended and the peak of charging current to the output capacitor is reduced, allowing the output voltage to rise gradually, thereby slowing the ramp rate of the output voltage, enabling the output voltage to reach the input voltage, reducing power loss, improving system efficiency, and enhancing operational safety.

FIG. 6 is a schematic diagram of a switching power supply according to a second embodiment of the present disclosure. The difference between the second embodiment and the first embodiment lies in that in the second embodiment two ends of the first diode D_{PL} are connected in parallel with an input capacitor C_{IN}. The short-circuit detection method of the present disclosure can also be compatible to the existence of the input capacitor C_{IN} to a certain extent, but the operating principle of the second embodiment is different in that, during the short-circuit detection phase, the bus protection switch Q1, the first diode D_{PL} and the inductor L cannot form a buck converter, but the bus protection switch Q1 can still output energy to the output terminal with a small duty cycle, so as to determine whether a short-circuit fault occurs by detecting whether the output voltage can rise to the predetermined value. The disadvantage of this method compared to the switching power supply of the first embodiment is that since the input current is not constrained by the inductor L, resulting in a larger input current.

It should be noted that, in the second embodiment, the capacitance value of the input capacitor C_{IN} has less influence on the short-circuit detection. When the capacitance value is small, for example, at the nF level, the soft-start phase after the short-circuit detection phase is basically not affected, however, if the capacitance value is close to the uF level, in the soft-start phase, the buck converter comprising the bus protection switch Q1, the first diode D_{PL} and the inductor L cannot operate normally, and can only be replaced in a hard-start mode.

It should be understood that the above-mentioned embodiments are only preferred embodiments of the present disclosure and are not intended to restrict the present disclosure. Any modification, equivalent replacement, improvement, etc. made to the present disclosure within the spirit and principle of the present disclosure should be included in the scope of the present disclosure.

## Claims

1. A switching power supply, comprising:
a boost converter, configured to perform voltage conversion on an input voltage of an input terminal of the switching power supply to generate an output voltage of an output terminal of the switching power supply in a normal operating phase;
a bus protection switch, coupled between the input terminal of the switching power supply and the boost converter, and configured to be turned off in response to a short-circuit fault of the switching power supply; and
a first diode, coupled between a common node between the bus protection switch and the boost converter and a ground terminal;
wherein a duty cycle of the bus protection switch is controlled to make the output voltage rises slowly in at least part of a startup phase, such that a short-circuit detection is performed.

2. The switching power supply according to claim 1, wherein the bus protection switch, the first diode, and an inductor in the boost converter form a buck converter, and the buck converter is configured to receive the input voltage, and convert the input voltage into the output voltage in the startup phase.

3. The switching power supply according to claim 2, further comprising a control circuit, wherein the control circuit is configured to control the buck converter to operate in a first time interval of the startup phase, to make the output voltage rise gradually, wherein in the first time interval, the control circuit determines whether the switching power supply has a short-circuit fault by comparing a feedback signal of the output voltage and a first threshold.

4. The switching power supply according to claim 3, wherein when the feedback signal of the output voltage is detected to be lower than the first threshold, the control circuit determines that the switching power supply has a short-circuit fault; and when the feedback signal of the output voltage can rise to the first threshold, the control circuit determines that no short-circuit fault is present in the switching power supply.

5. The switching power supply according to claim 3, wherein when the feedback signal of the output voltage rises to the first threshold during the first time interval, the control circuit is configured to initiate a soft start of the switching power supply in a second time interval of the startup phase, wherein the second time interval is after the first time interval.

6. The switching power supply according to claim 3, wherein when the feedback signal of the output voltage is detected to be lower than the first threshold during the first time interval of the startup phase or in the normal operating phase, the control circuit is configured to turn off the bus protection switch or be controlled to stop operating, and then reenter the startup phase after a predetermined delay.

7. The switching power supply according to claim 5, wherein in the second time interval, the control circuit controls the output voltage generated by the buck converter to soft start the switching power supply, to make the output voltage rise and approach the input voltage.

8. The switching power supply according to claim 5, wherein the buck converter has a first duty cycle range in the first time interval and a second duty cycle range in the second time interval, wherein every value within the second duty cycle range is greater than any value within the first duty cycle range.

9. The switching power supply according to claim 5, wherein the buck converter has a predetermined first duty cycle in the first time interval and a second duty cycle range in the second time interval, wherein every value within the second duty cycle range is greater than the predetermined first duty cycle.

10. The switching power supply according to claim 8 or 9, wherein a second duty cycle of the buck converter increases and remains within the second duty cycle range during the second time interval, wherein a maximum value of the second duty cycle range is 1.

11. The switching power supply according to claim 1, wherein the bus protection switch is a P-type field effect transistor, a source of the bus protection switch is coupled to the input terminal of the switching power supply, and a drain of the bus protection switch is coupled to the boost converter.

12. The switching power supply according to claim 1, wherein a short-circuit protection is implemented in the switching power supply without disposing a sampling circuit between the input terminal of the switching power supply and the boost converter.

13. The switching power supply according to claim 5, wherein the soft start of the switching power supply in the second time interval is implemented by controlling the operating states of the bus protection switch to reduce a change rate of a current of the inductor.

14. The switching power supply according to claim 8, wherein in the second time interval of the startup phase, the buck converter has a fixed third duty cycle within the second duty cycle range.

15. The switching power supply according to claim 2, the buck converter is controlled to operate to make a current of the inductor is within a preset current range in a first time interval of the startup phase, so the output voltage rises slowly to perform the short-circuit detection.
